# EUROPÄISCHE PATENTSCHRIFT

(11) **EP 3 914 919 B1**
(45) Veröffentlichungstag und Bekanntmachung des Hinweises auf die Patenterteilung: **12.07.2023**
(21) Anmeldenummer: 20703367.1
(22) Anmeldetag: 20.01.2020
(51) Int. Cl.: G01R 31/58, H01B 7/32

(54) **KABELANORDNUNG UND VERFAHREN ZUR ÜBERPRÜFUNG EINER KABELANORDNUNG**
CABLE ASSEMBLY AND METHOD FOR INSPECTING A CABLE ASSEMBLY
ENSEMBLE DE CÂBLES ET PROCÉDÉ DÉ VÉRIFICATION D'UN ENSEMBLE DE CÂBLES

(30) Priorität: 24.01.2019 AT 500542019
(43) Veröffentlichungstag der Anmeldung: 01.12.2021
(73) Patentinhaber: Piezocryst Advanced Sensorics GmbH, 8020 Graz (AT)
(72) Erfinder: SCHRICKER, Alexander, 8046 GRAZ (AT); MAYER, Andreas, 8113 ST. OSWALD BEI PLANKENWARTH (AT); LADINIG, Lukas, 8020 GRAZ (AT)
(74) Vertreter: Babeluk, Michael
(86) Internationale Anmeldenummer: PCT/AT2020/060012
(87) Internationale Veröffentlichungsnummer: WO 2020/150757

(56) Entgegenhaltungen:
- EP-A1- 0 246 576
- CA-A1- 2 298 713
- CN-A- 101 707 076
- CN-A- 105 510 646
- CN-A- 107 957 540
- DE-A1- 4 035 403
- DE-A1- 4 119 655
- GB-A- 1 469 314
- US-A- 3 461 416
- US-B1- 6 271 621

## Beschreibung

Die Erfindung betrifft eine Kabelanordnung, für Anwendungen in Hochdruck- und/oder Hochtemperaturbereichen, mit einem mineralisolierten Kabel, das zumindest einen Innenleiter aufweist, wobei der Innenleiter eine innere und eine äußere, rohrförmige Abschirmung aus Metall aufweist. Weiters betrifft die Erfindung ein Verfahren zur Überprüfung einer derartigen Kabelanordnung, für Anwendungen in Hochdruck- und/oder Hochtemperaturbereichen. Insbesondere bei Anwendungen in Hochdruck- und/oder Hochtemperaturbereichen, beispielsweise bei großen Gasturbinen, werden Druck- und Beschleunigungssensoren (Geschwindigkeitssensoren) mit mineralisolierten Metallmantelkabeln (MI-Kabel) verwendet. Diese Kabel können, z.B. durch Reiben an Wandungen, Durchführungen oder anderen Gegenständen beschädigt werden, sodass die Abschirmung durchgerieben wird und die Innenleiter, die das Messsignal führen, ungenügend isoliert oder freigelegt werden. Die dann an dieser Stelle erzeugten parasitären Signale können letztendlich zum Abschalten der Gasturbine führen. Parasitäre Signale entstehen durch Kurzschluss, Potentialdifferenzen sowie elektromagnetische Einstreuung.

Aus der EP 3 049 785 B1 ist beispielsweise ein Druckmesssystem mit einer in ein Prozessfluid einführbaren Drucksensoranordnung bekannt, wobei die Drucksensoranordnung eine an ein Sensormontageelement angeschweißte Buchse aufweist und der Drucksensor durch eine Lötverbindung mit dem Sensormontageelement verbunden ist. Die Drucksensoranordnung weist ein mineralisoliertes Kabel (MI-Kabel) mit einem Metallmantel auf, mit einem distalen Ende, das an der Buchse des Drucksensors angeschweißt ist, und einem proximalen Ende, das an einem Prozeßfluidbehälter abdichtend angebracht werden kann. Das mineralisolierte Kabel weist mehrere mit dem Drucksensor elektrisch verbundene Leiter auf, die sich mittels eines elektrisch isolierenden Trockenminerals voneinander beabstandet innerhalb des Metallmantels erstrecken. Eine Schweißung zwischen der Buchse und dem distalen Ende des Metallmantels bildet dabei eine erste Dichtung und eine Schweißung zwischen dem Mantel und dem Sensormontageelement eine zweite Dichtung. In nachteiliger Weise beeinflusst eine Beschädigung des Metallmantels direkt die Signalgüte der elektrischen Leiter.

In diesem Zusammenhang ist aus der CN 2015 14809 U und aus der CN 101 707 076 A ein doppelt geschirmtes MI-Kabel bekannt geworden. Zur Verlängerung der Serviceintervalle und Verbesserung der Signalgüte wird ein Kabel vorgeschlagen, das einen Kupferdraht als Innenleiter in einer Mineralisolierung aus MgO und eine Messingschirmung als äußeren Leiter aufweist. Konzentrisch dazu ist eine zweite Abschirmung aus Messing oder Stahl vorgesehen, wobei der Ringspalt zwischen den beiden Abschirmungen mit einer Mineralisolierung aus MgO gefüllt ist.

GB1469314 A bezieht sich auf eine Schaltungsanordnung zur Überwachung elektrischer Leitungen auf Fehler mit Stromkreisen über eine die Hauptleiter umgebende leitende Abschirmung, über einen Schutzleiter sowie über einen Steuerleiter. Aufgabe der vorliegenden Erfindung ist es, die eingangs beschriebenen Kabelanordnungen, für Anwendungen in Hochdruck- und/oder Hochtemperaturbereichen, derart zu verbessern, dass bei hoher Signalgüte am mineralisolierten Kabel auftretende Verschleißerscheinungen der Kabelanordnung rasch erkannt werden können. Weiters soll der notwendige Austausch eines von der Kabelanordnung kontaktierten Sensors zeitgerecht vorhergesagt werden können. Erfindungsgemäß wird dies dadurch erreicht, dass die Kabelanordnung zur frühzeitigen Erkennung von Kabelschäden eine Messeinrichtung zur Gewinnung eines Prüfsignals aufweist, die die innere und die äußere Abschirmung des mineralisolierten Kabels elektrisch kontaktiert.

Gemäß einer ersten Ausführungsvariante gemäss dem Anspruch 1 dient die Messeinrichtung dazu, den elektrischen Widerstand oder dessen zeitliche Änderung, insbesondere des Isolationswiderstands, zwischen der inneren und der äußeren Abschirmung zu messen und Abweichungen von vorgegebenen Signalparametern festzustellen.

Die erfinderische Idee besteht im Wesentlichen darin, ein einfach geschirmtes Kabel mit einer weiteren konzentrischen Abschirmung zu versehen und das Signal zwischen den beiden Schirmen zu überwachen. Im Normalbetrieb muss hier ein hoher Isolationswiderstand gegeben sein und es dürfen nur Rauschsignale kleiner Amplitude auftreten. Sobald der erste Schirm an einer beliebigen Stelle defekt bzw. durchgerieben ist, sinkt die elektrische Isolation der zwischengelagerten (hygroskopischen) Mineralisolierung um mehrere 10er-Potenzen. Dies führt bei entsprechend eingestellten Ladungsverstärkern zu einer Drift und in weiterer Folge zu einer Sättigung des Signals. Der Kurvenverlauf ist charakteristisch und zeigt ein ansteigendes Rauschsignal bis zu dem Zeitpunkt, an dem der Ladungsverstärker aufgrund zu hoher Signaldrift in Sättigung gerät und ein konstantes Signal bei maximaler oder minimaler Ausgangsspannung abgibt.

Eine exemplarische Variante verwendet eine Messeinrichtung, die geeignet ist, die elektrische Kapazität oder deren zeitliche Änderung zwischen der inneren und der äußeren Abschirmung zu messen. Bei einer defekten äußeren Abschirmung ändert sich die Dielektrizitätskonstante der Mineralisolierung zwischen den beiden Abschirmungen, was zu einer messbaren Änderung der elektrischen Kapazität führt.

Die Messeinrichtung weist einen Ladungsverstärker auf, dessen Signaleingänge die innere und die äußere Abschirmung elektrisch kontaktieren. Das vom Ladungsverstärker der Messeinrichtung generierte Prüfsignal kann überwacht werden, wobei bei Veränderung vorgegebener Signalparameter entsprechende Wartungsschritte eingeleitet werden können.

Ein erfindungsgemäßes Verfahren zur Überprüfung einer Kabelanordnung ist im Anspruch 6 angegeben.

Die Erfindung wird im Folgenden an Hand von Ausführungsbeispielen näher erläutert. Es zeigen:
- Fig. 1: eine erfindungsgemäße Kabelanordnung, vorzugsweise für Anwendungen in Hochdruck- und/oder Hochtemperaturbereichen in Kontakt mit einem Druck- oder Beschleunigungssensor in einem Längsschnitt;
- Fig. 2: eine Variante der erfindungsgemäßen Kabelanordnung gemäß Fig. 1 in einem Längsschnitt;
- Fig. 3: ein Detail A aus den Fig. 1 und Fig. 2 in vergrößerter Darstellung;
- Fig. 4: ein Detail B aus den Fig. 1 und Fig. 2 in vergrößerter Darstellung;
- Fig. 5: eine Schnittdarstellung des mineralisolierten Kabels gemäß Linie V-V in Fig. 2 in vergrößerter Darstellung;
- Fig. 6: eine Ausführungsvariante des mineralisolierten Kabels in einer Schnittdarstellung gemäß Fig. 5;
- Fig. 7: ein Diagramm eines Signalverlaufs ohne Schäden am mineralisolierten Kabel; sowie
- Fig. 8: ein Diagramm eines Signalverlaufs eines schadhaften mineralisolierten Kabels.

Funktionsgleiche Teile sind in den Ausführungsvarianten mit gleichen Bezugszeichen versehen.

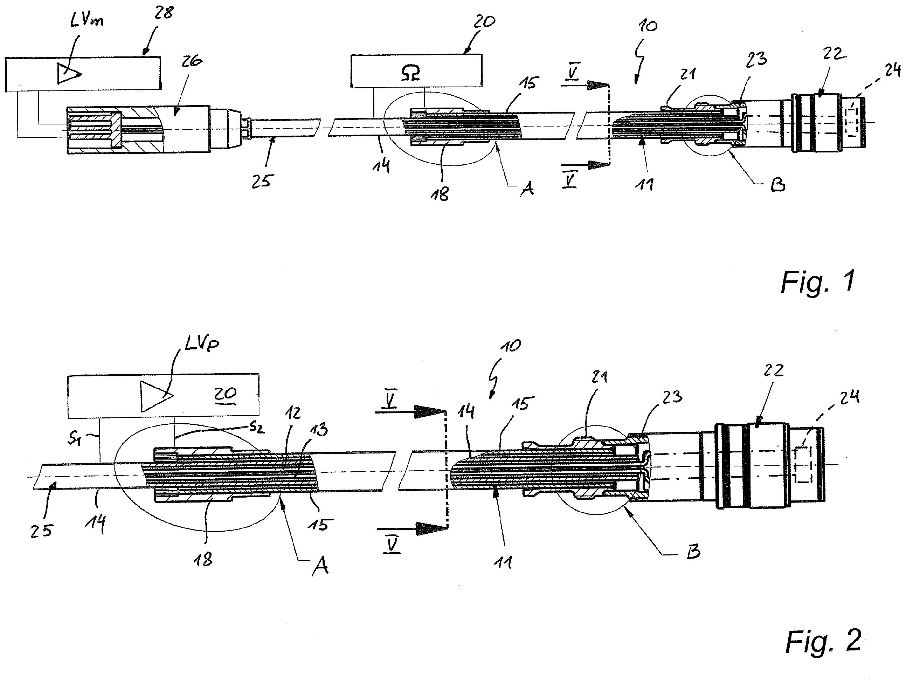

Bei der Kabelanordnung 10 gemäß Fig. 1 ist das mineralisolierte Kabel (MI-Kabel) 11 gasdicht am Gehäuse 23 eines piezoelektrischen Sensors 22 (Druck- oder Beschleunigungssensor) befestigt, bevorzugt mit diesem verschweißt. Der Messwandler 24 des Sensors 22 ist strichliert angedeutet. Das MI-Kabel 11 weist zwei im Abstand zueinander, parallel geführte, mineralisolierte Innenleiter 12, 13 auf, die in einer inneren 14 und einer konzentrisch dazu angeordneten, äußeren Abschirmung 15 aus Metall angeordnet sind, wobei zwischen den beiden Abschirmungen eine Mineralisolierung 17 vorliegt.

Das doppelt geschirmte Kabel 11 weist eine Messfunktion auf, indem eine Messeinrichtung 20 vorgesehen ist, mit welcher der Isolierungswiderstand zwischen der inneren 14 und der äußeren Abschirmung 15 gemessen werden kann. Sinkt dieser Widerstand, beispielsweise wenn die äußere Abschirmung 15 durchgescheuert ist und Feuchtigkeit in die Mineralisolierung 17 eindringt, so kann frühzeitig, noch bevor sich die Signalgüte wesentlich verschlechtert, eine Beschädigung des MI-Kabels 11 festgestellt werden.

Die Messeinrichtung 20 kann beispielsweise im Bereich einer Metallhülse 18 angeordnet sein, die mit dem MI-Kabel 11 vergossen ist, wobei aus der Metallhülse 18 ein einfach geschirmtes Steckerkabel 25 austritt, das zu einem zweipoligen Gerätestecker 26 (z.B. ein LEMO^{®}-Stecker) führt. Der Gerätestecker 26 wird an eine Auswerteeinheit 28 angeschlossen deren Ladungsverstärker LVm ein Messsignal generiert.

Es ist auch möglich das doppelt geschirmte MI-Kabel 11 mit einem vierpoligen Stecker zu versehen, sodass in einer daran angeschlossenen Auswerteeinheit 28 sowohl das Prüfsignal als auch das Messsignal generiert werden können.

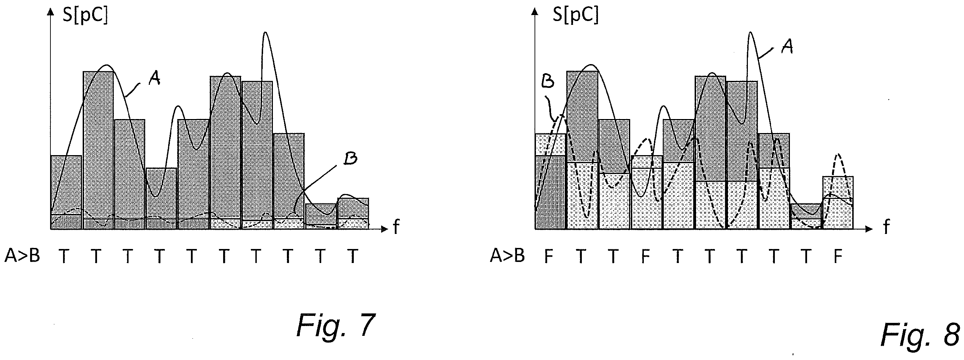

Die Ausführungsvariante gemäß Fig. 2 ist im Wesentlichen gleich aufgebaut wie jene gemäß Fig. 1. Der Unterschied liegt in der Messeinrichtung 20, die einen Ladungsverstärker LVp aufweist, dessen Signaleingänge s₁, s₂ die innere und die äußere Abschirmung 14, 15 des MI-Kabels 11 elektrisch kontaktieren. Es kann somit das Ladungssignal zwischen den beiden Abschirmungen 14, 15 gemessen werden. Ist das Prüfsignal bzw. Rauschsignal (beispielsweise in Abschnitten des gemessenen Spektrums) höher als das Messsignal kann auf eine Beschädigung der äußeren Abschirmung 15 geschlossen werden (siehe Diagramme Fig. 7 und Fig. 8).

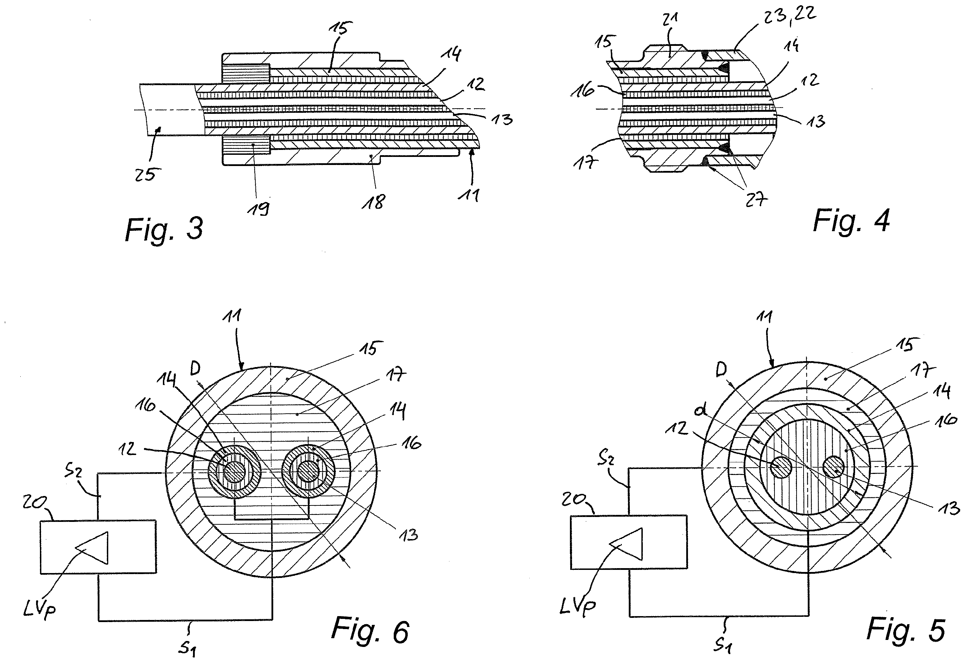

Fig. 3 zeigt im Detail den Übergang vom doppelt geschirmten MI-Kabel 11 zum einfach geschirmten Steckerkabel 25. Das MI-Kabel 11 weist an dem vom Druck-oder Beschleunigungssensor 22 abgewandten Ende eine die äußere Abschirmung 15 des MI-Kabels 11 umfassende Metallhülse 18 auf, aus der das Steckerkabel 25 austritt, wobei die Metallhülse 18 mittels Vergussmasse 19 gasdicht an der inneren Abschirmung 14 des MI-Kabels 11 abgedichtet ist.

Fig. 4 zeigt im Detail den gasdichten Anschluss des MI-Kabels 11 an den Druck-oder Beschleunigungssensor 22. Das Gehäuse 23 des Druck- oder Beschleunigungssensors 22 kann direkt an der äußeren Abschirmung 15 des MI-Kabels 11 (oder indirekt über einen Kabelschuh 21) befestigt, vorzugsweise mit der äußeren Abschirmung 15 oder dem Kabelschuh 21 verschweißt sein (siehe Verschweißungen 27). Die beiden Innenleiter 12, 13 des MI-Kabels 11 kontaktieren den Messwandler 24 des Druck- oder Beschleunigungssensors 22.

In Fig. 5 ist der innere Aufbau des MI-Kabels 11 gemäß Linie V-V in den Figuren 1 bzw. 2 im Detail dargestellt. Das MI-Kabel 11 weist zwei in der inneren Abschirmung 14 angeordnete Innenleiter 11, 12 auf, die mit Abstand zueinander in einer ersten Mineralisolierung 16 eingebettet sind, wobei die äußere Abschirmung 15 die innere Abschirmung 14 unter Zwischenlage einer zweiten Mineralisolierung 17 umfasst.

Gemäß der in Fig. 6 dargestellten Variante kann das MI-Kabel 11 auch zwei Innenleiter 11, 12 aufweisen, die jeweils in einer ersten Mineralisolierung 16 in separaten inneren Abschirmungen 14 angeordnet sind, wobei die zwei inneren Abschirmungen 14 in eine zweite Mineralisolierung 17 eingebettet und von der äußeren Abschirmung 15 umfasst sind.

Die beiden Abschirmungen 14, 15 können beispielsweise aus Nickel-, Stahl- oder Aluminiumlegierungen bestehen. Für die Mineralisolierung kann beispielsweise MgO oder SiOz verwendet werden.

Der Durchmesser D der äußeren Abschirmung 15 liegt beispielsweise bei 3 mm bis 10 mm, vorzugsweise bei 4 mm bis 8 mm. Der Durchmesser d der inneren Abschirmung 14 beträgt - abhängig von der Ausführungsvariante (siehe Fig. 5 und Fig. 6) - beispielsweise 1,5 mm bis 5 mm.

In den Fig. 7 und Fig. 8 sind zwei Messbeispiele mit einer Vorrichtung gemäß Fig. 2 dargestellt.

In Fig. 7 ist der Frequenzverlauf der beiden Signale (Messsignal A des Ladungsverstärkers LVm sowie Prüfsignal B des Ladungsverstärkers LVp) dargestellt. Bei einer intakten äußeren Abschirmung 15 ist das Prüfsignal bzw. Rauschsignal B in allen Frequenzabschnitten T kleiner als das Messsignal A.

Ist die äußere Abschirmung 15 beschädigt, so zeigen sich Frequenzabschnitte F in welchen das Prüfsignal bzw. Rauschsignal B größer ist als das Messsignal A (siehe Fig. 8).

## Patentansprüche

1. Kabelanordnung (10) geeignet für Anwendungen in Hochdruck- und/ oder Hochtemperaturbereichen, mit einem mineralisolierten Kabel (11), das zumindest einen Innenleiter (12, 13) aufweist, wobei der Innenleiter (12, 13) eine innere und eine äußere, rohrförmige Abschirmung (14, 15) aus Metall aufweist, **dadurch gekennzeichnet, dass** die Kabelanordnung (10) eine Messeinrichtung (20) zur Gewinnung eines Prüfsignals aufweist, die die innere und die äußere Abschirmung (14, 15) des mineralisolierten Kabels (11) elektrisch kontaktiert, wobei die Messeinrichtung (20) eingerichtet ist, den elektrischen Widerstand, insbesondere den Isolationswiderstand, zwischen der inneren und der äußeren Abschirmung (14, 15) zu messen, oder wobei die Messeinrichtung (20) zur Messung von Ladungssignalen einen Ladungsverstärker (LVp) aufweist, dessen Signaleingänge (s₁, s₂) die innere und die äußere Abschirmung (14, 15) elektrisch kontaktieren.

2. Kabelanordnung (10) nach Anspruch 1, **dadurch gekennzeichnet, dass** das mineralisolierte Kabel (11) mehrere in der inneren Abschirmung (14) angeordnete Innenleiter (12, 13) aufweist, die mit Abstand zueinander in einer ersten Mineralisolierung (16) eingebettet sind, wobei die äußere Abschirmung (15) die innere Abschirmung (14) unter Zwischenlage einer zweiten Mineralisolierung (17) umfasst.

3. Kabelanordnung (10) nach Anspruch 1, **dadurch gekennzeichnet, dass** das mineralisolierte Kabel (11) mehrere Innenleiter (12, 13) aufweist, die jeweils in einer ersten Mineralisolierung (16) in inneren Abschirmungen (14) angeordnet sind, wobei die inneren Abschirmungen (14) in eine zweite Mineralisolierung (17) eingebettet und von der äußeren Abschirmung (15) umfasst sind.

4. Kabelanordnung (10) nach einem der Ansprüche 1 bis 3 zur Kontaktierung eines Druck- oder Beschleunigungssensors (22), **dadurch gekennzeichnet, dass** das Gehäuse (23) des Druck- oder Beschleunigungssensors (22) direkt oder indirekt an der äußeren Abschirmung (15) des mineralisolierten Kabels (11) befestigt, vorzugsweise mit der äußeren Abschirmung (15) verschweißt ist, und der zumindest eine Innenleiter (12, 13) des mineralisolierten Kabels (11) einen Messwandler (24) des Druck- oder Beschleunigungssensors (22) elektrisch kontaktiert.

5. Kabelanordnung (10) nach Anspruch 4, **dadurch gekennzeichnet, dass** das mineralisolierte Kabel (11) an dem vom Druck- oder Beschleunigungssensor (22) abgewandten Ende eine die äußere Abschirmung (15) des mineralisolierten Kabels (11) umfassende Metallhülse (18) aufweist, aus der ein Steckerkabel (25) austritt, wobei die Metallhülse (18) mittels einer Vergussmasse (19) an der inneren Abschirmung (14) des mineralisolierten Kabels (11) abgedichtet ist.

6. Verfahren zur Überprüfung einer Kabelanordnung (10) nach Anspruch 1, **gekennzeichnet durch** folgende Schritte:
a) elektrische Kontaktierung der inneren und der äußeren Abschirmung des mineralisolierten Kabels (11);
b) Gewinnung eines elektrischen Signals, das ein vom Widerstand oder der Ladung abhängiges Signal ist;
c) Überprüfung des Signalverlaufs; sowie
d) Feststellung eines Schadens am mineralisolierten Kabel (11) bei Abweichung des im Schritt b) gewonnenen elektrischen Signals von vorgegebenen Parametern.

## Claims

1. Cable assembly (10) suitable for applications in high-pressure and/or high-temperature ranges, having a mineral-insulated cable (11) which has at least one inner conductor (12, 13), wherein the inner conductor (12, 13) has an inner and an outer tubular shield (14, 15) made of metal, **characterised in that** the cable assembly (10) has a measuring device (20) for obtaining a test signal, which measuring device (20) electrically contacts the inner and the outer shield (14, 15) of the mineral-insulated cable (11), wherein the measuring device (20) is adapted to measure the electrical resistance, in particular the insulation resistance, between the inner and outer shield (14, 15), or wherein the measuring device (20) has a charge amplifier (LVp) for measuring charge signals, the signal inputs (s₁, s₂) of which electrically contact the inner and outer shield (14, 15).

2. Cable assembly (10) according to claim 1, **characterised in that** the mineral-insulated cable (11) has a plurality of inner conductors (12, 13) which are arranged in the inner shield (14) and are embedded at a distance from one another in a first mineral insulation (16), wherein the outer shield (15) comprises the inner shield (14) with the interposition of a second mineral insulation (17).

3. Cable assembly (10) according to claim 1, **characterised in that** the mineral-insulated cable (11) comprises a plurality of inner conductors (12, 13) which are each arranged in inner shields (14) in a first mineral insulation (16), wherein the inner shields (14) are embedded in a second mineral insulation (17) and are surrounded by the outer shield (15).

4. Cable assembly (10) according to one of claims 1 to 3 for contacting a pressure or acceleration sensor (22), **characterised in that** the housing (23) of the pressure or acceleration sensor (22) is directly or indirectly attached to the outer shield (15) of the mineral-insulated cable (11), preferably welded to the outer shield (15), and the at least one inner conductor (12, 13) of the mineral-insulated cable (11) electrically contacts a transducer (24) of the pressure or acceleration sensor (22).

5. Cable assembly (10) according to claim 4, **characterised in that** the mineral-insulated cable (11) has, at the end facing away from the pressure or acceleration sensor (22), a metal sleeve (18) which surrounds the outer shield (15) of the mineral-insulated cable (11) and from which a plug cable (25) emerges, wherein the metal sleeve (18) is sealed to the inner shield (14) of the mineral-insulated cable (11) by means of a sealing compound (19).

6. Method for testing a cable assembly (10) according to claim 1, **characterised by** the following steps:
a) electrically contacting the inner and outer shield of the mineral-insulated cable (11);
b) obtaining an electrical signal which is a resistance or charge-dependent signal;
c) verification of the signal characteristics; and
d) determining damage to the mineral-insulated cable (11) if the electrical signal obtained in step b) deviates from predetermined parameters.

## Revendications

1. Dispositif de câble (10) pour des applications dans le domaine des hautes pressions et/ou des hautes températures, comprenant un câble à isolant minéral (11) ayant au moins un conducteur intérieur (12, 13),
- le conducteur intérieur (12, 13) ayant des blindages intérieur et extérieur, tubulaires (14, 15) en métal, dispositif de câble (10) **caractérisé en ce qu'**il comprend une installation de mesure (20) pour recueillir un signal de vérification, cette installation étant en contact avec les blindage intérieur et extérieur (14, 15) du câble à isolant minéral (11),
- l'installation de mesure (20) étant conçue pour mesurer la résistance électrique notamment la résistance d'isolation entre les blindages intérieur et extérieur (14, 15), ou
- l'installation de mesure (20) est prévue pour mesurer des signaux de charge d'un amplificateur de charge (LVp) dont les entrées de signal (s₁, s₂) sont en contact électrique avec les blindages intérieur et extérieur (14, 15).

2. Dispositif de câble (10) selon la revendication 1,
**caractérisé en ce que**
le câble à isolant minéral (11) comporte plusieurs conducteurs intérieurs (12, 13) dans le blindage intérieur (14), ces conducteurs étant intégrés écartés les uns des autres dans un premier isolant minéral (16), - le blindage extérieur (15) entourant le blindage intérieur (14) avec interposition d'un second isolant minéral (17).

3. Dispositif de câble (10) selon la revendication 1,
**caractérisé en ce que**
le câble à isolant minéral (11) comporte plusieurs conducteurs intérieurs (12, 13) qui sont prévus dans un premier isolant minéral (16) dans plusieurs blindages intérieurs (14), les blindages intérieurs (14) étant intégrés dans un second isolant minéral (17) en étant entourés par le blindage extérieur (15).

4. Dispositif de câble (10) selon l'une des revendications 1 à 3,
pour la mise en contact avec un capteur de pression ou d'accélération (22),
**caractérisé en ce que**
le boîtier (23) du capteur de pression ou d'accélération (22) est fixé directement ou indirectement dans le blindage extérieur (15) du câble à isolant minéral (11) en étant soudé, de préférence au blindage extérieur (15) et au moins le conducteur intérieur (12, 13) du câble à isolant minéral (11) est en contact électrique avec un convertisseur de mesure (24) du capteur de pression ou d'accélération (22).

5. Dispositif de câble (10) selon la revendication 4,
**caractérisé en ce que**
le câble à isolant minéral (11) comporte à son extrémité opposée à celle du capteur de pression ou d'accélération (22), un manchon métallique (18) entourant le blindage extérieur (15) du câble à isolant minéral (11), ce manchon sortant d'un connecteur de câble (25),
le manchon métallique (18) étant rendu étanche par une masse coulée (19) au niveau du blindage intérieur (14) du câble à isolant minéral (11).

6. Procédé de vérification d'un dispositif de câble (10) selon la revendication 1,
comprenant les étapes suivantes :
a) branchement électrique du blindage intérieur et du blindage extérieur du câble à isolant minéral (11),
b) collecte d'un signal électrique dépendant de la résistance ou de la charge,
c) vérifier le chronogramme du signal, et
d) constater un dommage d'un câble à isolant minéral (11) en cas d'écart du signal électrique recueilli dans l'étape b) par rapport à des paramètres prédéfinis.
